# EUROPÄISCHE PATENTSCHRIFT

(11) **EP 2 649 868 B1**
(45) Veröffentlichungstag und Bekanntmachung des Hinweises auf die Patenterteilung: **25.02.2015**
(21) Anmeldenummer: 11802319.1
(22) Anmeldetag: 06.12.2011
(51) Int. Cl.: H05K 1/18, B60T 7/04

(54) **LEITERPLATTENANORDNUNG MIT EINEM ZWISCHEN EINER LEITERPLATTE UND EINEM LEITERPLATTENTRÄGER GEKLEMMTEN MIKROSCHALTER**
PRINTED CIRCUIT BOARD ARRANGEMENT HAVING A MICROSWITCH CLAMPED BETWEEN A PRINTED CIRCUIT BOARD AND A PRINTED CIRCUIT BOARD CARRIER
ENSEMBLE CARTE DE CIRCUIT IMPRIMÉ COMPORTANT UN MICRO-CONTACTEUR COLLÉ ENTRE UNE CARTE DE CIRCUIT IMPRIMÉ ET UN SUPPORT DE CARTE DE CIRCUIT IMPRIMÉ

(30) Priorität: 10.12.2010 DE 102010054050
(43) Veröffentlichungstag der Anmeldung: 16.10.2013
(73) Patentinhaber: KNORR-BREMSE Systeme für Nutzfahrzeuge GmbH, 80809 München (DE)
(72) Erfinder: SCHMAUDER, Thilo, 71732 Tamm (DE)
(86) Internationale Anmeldenummer: PCT/EP2011/071880
(87) Internationale Veröffentlichungsnummer: WO 2012/076508

(56) Entgegenhaltungen:
- US-A- 4 293 764
- US-A- 4 901 055
- US-A- 5 434 377

## Beschreibung

### Stand der Technik

Die Erfindung geht aus von einer Leiterplattenanordnung mit einer mit Bauteilen bestückbaren Leiterplatte, welche wenigstens einen Mikroschalter umfassen, wobei die Leiterplatte an einem Leiterplattenträger befestigt ist gemäß dem Oberbegriff von Anspruch 1.

Unter einem Mikroschalter wird im Allgemeinen ein elektrischer Schalter verstanden, dessen Kontakte im geöffneten Zustand weniger als 3 mm Abstand voneinander haben. Eine bekannte Bauform ist beispielsweise der Mikroschalter mit schnappendem System. Weiterhin sind auch Bauformen als Öffner und Schließer sowie als Wechsler mit den drei Anschlüssen Öffnerkontakt, Schließerkontakt und Schaltzunge bekannt. Durch den geringen Kontaktabstand eignen sich Mikroschalter lediglich für das Schalten geringer Lasten. Meist wirken Mikroschalter mit elektrischen und elektronischen Schaltungen zusammen, die auf einer Leiterplatte angeordnet sind. Nicht zuletzt dienen Mikroschalter dazu, der Lageposition von beweglichen Bauelemente, wie beispielsweise von Werkzeugmaschinenschlitten entsprechende Signale für eine elektronische Steuerung zu erzeugen, insbesondere in der Funktion als Endlagenschalter. Üblicherweise besitzen Gehäuse von Mikroschaltern zwei Durchgangsbohrungen, von welchen eine Durchgangsbohrung zylindrisch und die andere Durchgangsbohrung zwei halbkreisförmige Bögen mit dazwischen ausgebildeten rechtwinkeligen Abschnitten ähnlich einem Langloch aufweist. Dabei wird ein solcher Mikroschalter oftmals mittels durch diese Durchgangsbohrungen gesteckte Stifte oder Schrauben an einem Grundkörper befestigt.

Eine gattungsgemäße Leiterplattenanordnung ist beispielsweise aus der DE 20 2010 000 045 U1 bekannt. Dort sind mehrere Mikroschalter auf einer Leiterplatte angeordnet, welche von einem Tastring betätigt werden.

Vor allem bei sicherheitsrelevanten Anwendungen, vor allem im Bereich von Fahrzeugbremssystemen ist eine zuverlässige Funktion von Mikroschaltern gefordert, insbesondere um ein Erreichen von bestimmten Positionen von Bremsbetätigungsorganen durch entsprechende elektrische Signale anzuzeigen. Für eine zuverlässige Funktion eines Mikroschalters ist daher zum einen eine korrekte Positionierung in Bezug zu dem jeweiligen Betätigungselement entscheidend wie auch eine Fixierung des Mikroschalters in dieser Position über einen möglichst langen Zeitraum. Andererseits besteht bei bauraumbeschränkten Anwendungen wie beispielsweise bei im Fußraum von Kraftfahrzeugen verbauten Fußbremsmoduln das Problem, dass Mikroschalter möglichst platzsparend verbaut werden müssen.

Der vorliegenden Erfindung liegt daher die Aufgabe zugrunde, eine Leiterplattenanordnung der eingangs erwähnten Art derart weiter zu entwickeln, dass der wenigstens eine von ihr umfasste Mikroschalter einerseits in seiner Position zuverlässig und dauerhaft fixiert ist und seine Befestigung andererseits platzsparend ist.

Diese Aufgabe wird erfindungsgemäß durch die Merkmale von Anspruch 1 gelöst.

### Offenbarung der Erfindung

Die Erfindung basiert auf dem Gedanken, dass der Mikroschalter zwischen der Leiterplatte und dem Leiterplattenträger aufgrund der durch die Befestigung der Leiterplatte am Leiterplattenträger hervorgerufenen Normalkräfte mittels reibschlüssiger Klemmung gehalten ist. Diese reibschlüssige Klemmung gewährleistet dann für sich bzw. zusammen mit zusätzlichen formschlüssigen Maßnahmen, dass die Position des Mikroschalters relativ zur Leiterplatte und zum Leiterplattenhalter dauerhaft fixiert ist.

Dadurch besitzt die Befestigung der Leiterplatte am Leiterplattenträger eine vorteilhafte Doppelfunktion, als diese einerseits die Leiterplatte am Leiterplattenträger als auch den Mikroschalter zwischen der Leiterplatte und dem Leiterplatteträger befestigt. Dann können elektrische Kontakte des Mikroschalters unmittelbar und direkt Leiterbahnen auf der Leiterplatte kontaktieren, wobei die sich dabei ausbildenden elektrischen Kontakte durch die Normalkräfte der Klemmung hergestellt bzw. gesichert werden. Weiterhin spart diese Anordnung Bauraum, weil keine zusätzlichen Befestigungsmittel vorgesehen werden müssen, etwa durch die Durchgangsbohrungen des Gehäuses des Mikroschalters ragende Schrauben, deren Schraubenköpfe über das Gehäuse hinausragen und eine direkte Klemmung an der Gehäusefläche verhindern würden.

Durch die in den Unteransprüchen aufgeführten Maßnahmen sind vorteilhafte Weiterbildungen und Verbesserungen der in den unabhängigen Ansprüchen angegebenen Erfindung möglich.

Wie bereits oben angedeutet spannen die durch die Klemmung des Mikroschalters zwischen der Leiterplatte und dem Leiterplattenträger hervorgerufenen Normalkräfte bevorzugt auch elektrische Kontakte des Mikroschalters gegen korrespondierende elektrische Kontakte der Leiterplatte vor. Dann dient die Klemmung des Mikroschalters einerseits dazu, diesen dauerhaft in seiner vorbestimmten Position zu halten und andererseits, um den elektrischen Kontakt des Mikroschalters mit den zugeordneten oder korrespondierenden elektrischen Kontakten auf der Leiterplatte herzustellen bzw. zu halten.

Alternativ könnten auch die elektrischen Kontakte zwischen dem Mikroschalter und der Leiterplatte frei von Klemmkräften sein, indem die elektrischen Kontakte des Mikroschalters, insbesondere in Durchgangsbohrungen der Leiterplatte angeordnet sind und dort gebondete elektrische Kontaktfüße beispielsweise seitlich und außerhalb des Klemmbereichs angeordnet sind.

Weiterhin besonders bevorzugt weist die Leiterplatte wenigstens zwei Durchgangsbohrungen aufweist, durch welche am Leiterplattenträger gekonterte Schrauben ragen. Durch Einschrauben dieser Schrauben in zugeordnete Schraubbohrungen oder Schraubdome am Leiterplattenträger erzeugen dann die für die Klemmung notwendigen Normalkräfte. Diese können alternativ oder zusätzlich durch beliebige Befestigungsmöglichkeiten hervorgerufen werden, beispielsweise auch durch einen oder mehrere um das durch die Leiterplatte, den Mikroschalter und den Leiterplattenträger gebildete Paket gespannte Spannmittel wie Spannringe.

Üblicherweise ist das Gehäuse des Mikroschalters plattenförmig ausgebildet. Weiterhin weist das Gehäuse des Mikroschalters wie üblich zwei in Klemmrichtung verlaufende Durchgangsbohrungen auf.

Dann können vom Leiterplattenträger bevorzugt zwei Haltestifte weg- und in diese Durchgangsbohrungen des Gehäuses des Mikroschalters hineinragen, um den Mikroschalter in seiner Lage in einer Ebene senkrecht zur Klemmrichtung zusätzlich zu fixieren. Dann ist der Mikroschalter durch die in seinen beiden Durchgangsbohrungen ragenden Haltestifte des Leiterplattenträgers in einer zu seinen Gehäuseseitenflächen parallelen Ebene formschlüssig lagefixiert, wobei die hierzu senkrechte Klemmung zwischen der Leiterplatte und dem Leiterplattenträger diese Position sichert. Insgesamt ergibt sich dadurch eine sehr sichere Lagefixierung des Mikroschalters an der Leiterplatte bzw. am Leiterplattenträger.

Die Betätigungsrichtung eines aus dem Gehäuse ragenden Betätigungselements des Mikroschalters ist dann bevorzugt im wesentlichen senkrecht zu den durch die Klemmung zwischen der Leiterplatte und dem Leiterplattenträger hervorgerufenen Normalkräften, wobei die optional zusätzlichen Haltstifte zusammen mit den reibschlüssigen Klemmkräften dann die aus der Betätigung herrührenden Betätigungskräfte aufnehmen. Alternativ könnte die Lage des Mikroschalters in Bezug zur Leiterplatte bzw. zu dem betätigenden Element auch derart sein, dass die Betätigungsrichtung des Betätigungselements beliebig ist, insbesondere auch parallel zu den durch die Klemmung hervor gerufenen Normalkräftenn.

Gemäß einer besonders bevorzugten Anwendung der erfindungsgemäßen Leiterplattenanordnung ist diese in einem Fußbremsmodul einer Bremsanlage eines Fahrzeugs verbaut, weil es dort, wie bereits eingangs erwähnt, auf eine besonders zuverlässige Lagefixierung und kompakte Anordnung von mit Leiterplatten elektrisch zusammenwirkenden Mikroschaltern ankommt. Dabei betätigt beispielsweise ein Kolben des Fußbremsmoduls das Betätigungselement des Mikroschalters in Betätigungsrichtung.

Genaueres geht aus der folgenden Beschreibung eines Ausführungsbeispiels hervor.

### Zeichnung

Nachstehend ist ein Ausführungsbeispiel der Erfindung in der Zeichnung dargestellt und in der nachfolgenden Beschreibung näher erläutert. In der Zeichnung zeigt
- Fig.1: einen Längsschnitt durch eine Leiterplattenanordnung mit einem zwischen einer Leiterplatte und einem Leiterplattenträger geklemmten Mikroschalter gemäß einer bevorzugten Ausführungsform der Erfindung;
- Fig.2: eine Draufsicht auf die Leiterplattenanordung von Fig.1.

### Beschreibung des Ausführungsbeispiels

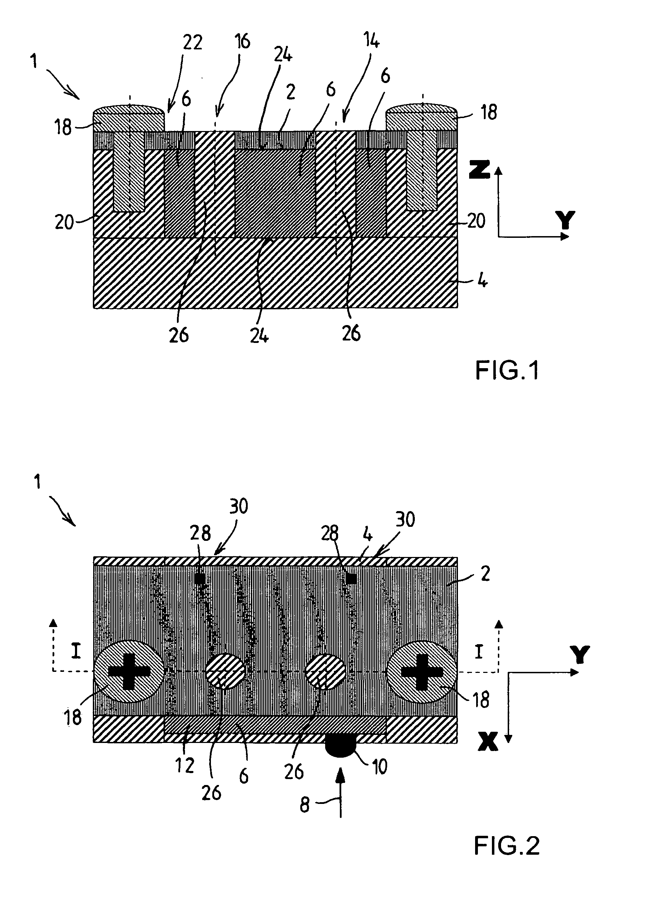

Die in Fig.1 gezeigte Leiterplattenanordnung 1 ist gemäß einer bevorzugten Ausführungsform in ein Fußbremsmodul einer elektro-pneumatischen Bremsanlage eines Nutzfahrzeugs integriert und beinhaltet eine Leiterplatte 2, einen Leiterplattenträger 4 sowie wenigstens einen Mikroschalter 6. Der Leiterplattenträger 4 ist dabei beispielsweise ein Lagerbock des Fußbremsmoduls, der hier nicht gezeigt ist.

Ein solches Fußbremsmodul ist hinreichend bekannt beispielsweise aus dem Kraftfahrtechnischen Taschenbuch, Herausgeber Robert Bosch GmbH, 26. Auflage 2007, Seiten 876 bis 877.

In einem solchen Fußbremsmodul sind neben einer Fußbremsplatte auch die Bauteile eines ein- oder mehrkreisigen Betriebsbremsventils aufgenommen. Ein solches Betriebsbremsventil weist einen von einer Fußbremsplatte betätigten Stößel auf, welcher mit einer im Gehäuse des Betriebsbremsventils axial beweglichen kolbenartigen Stößelaufnahme zusammen wirkt. Diese Stößelaufnahme wirkt wiederum durch Federmittel auf einen Reaktionskolben, welcher den hier in Frage stehenden Mikroschalter 6 betätigt, wodurch der Mikroschalter 6 ein elektrisches Signal erzeugt (Verbindung oder Trennung eines elektrischen Kreises) und dadurch eine bestimmte Lage des Reaktionskolbens signalisiert. Dieses hier beispielsweise knopfartige und in einer durch einen Pfeil 8 symbolisierten Betätigungsrichtung betätigbare Betätigungselement 10 ragt aus einem Gehäuse 12 des Mikroschalters 6 heraus.

Der Mikroschalter 6 ist bevorzugt handelsüblich, wobei sein Gehäuse 12 plattenförmig ausgebildet ist, d.h. seine flächige Ausdehnung ist größer als seine in Fig.1 sichtbare Dicke. Weiterhin weist das Gehäuse 12 des Mikroschalters 6 zwei senkrecht zur Plattenebene seiner plattenförmigen Ausbildung verlaufende Durchgangsbohrungen 14, 16 auf, wovon die eine Durchgangsbohrung 14 mit beispielsweise zylindrischem Querschnitt ausgebildet ist und die andere Durchgangsbohrung 16 zwei halbkreisförmige Bögen mit dazwischen ausgebildeten rechtwinkeligen Abschnitten ähnlich einem Langloch aufweist.

Die Leiterplatte 2 dient bevorzugt als Kontaktleiterplatte für den Mikroschalter 6, zusätzlich können auf ihr allerdings auch noch weitere elektrische und/oder elektronische Bauelemente verbaut sein. Diese Leiterplatte 2 ist bevorzugt mittels Schrauben 18 am Leiterplattenträger 4 gehalten. Dies kann beispielsweise dadurch realisiert sein, dass vom Leiterplattenträger 4 Schraubdome 20 weg ragen, in welche die durch Durchgangsbohrungen 22 in der Leiterplatte 2 gesteckte Schrauben eingeschraubt sind.

Dabei ist der Mikroschalter 6 zwischen der Leiterplatte 2 und dem Leiterplattenträger 4 aufgrund der durch die beispielsweise durch die Schrauben 18 bewerkstelligte Befestigung der Leiterplatte 2 am Leiterplattenträger 4 hervorgerufenen Normalkräfte wenigstens mittels reibschlüssiger Klemmung gehalten. Mit anderen Worten üben die durch die Schrauben 18 hervorgerufenen und in Fig.1 und Fig.2 in Z-Richtung weisenden Normalkräfte eine beidseitige Klemmkraft auf den Mikroschalter 6 und genauer auf seine seitlichen und parallel zu seiner Plattenebene verlaufenden Seitenflächen 24 aus. Der Mikroschalter 6 ist dabei in Plattenebene gesehen bevorzugt zwischen den Schraubdomen 20 des Leiterplattenträgers 4 angeordnet.

Im vorliegenden Fall ist die Betätigungsrichtung 8 des aus dem Gehäuse 12 ragenden Betätigungselements 10 des Mikroschalters 6 im wesentlichen senkrecht zu den durch die Klemmung zwischen der Leiterplatte 2 und dem Leiterplattenträger 4 hervorgerufenen Normalkräften, wie insbesondere aus Fig.2 hervorgeht. Alternativ könnte die Betätigungsrichtung auch jede beliebige Richtung einnehmen, insbesondere auch parallel zu den Normalkräften.

Darüber hinaus ragen vom Leiterplattenträger 4 bevorzugt zwei Haltestifte 26 weg- und in die beiden Durchgangsbohrungen 14, 16 des Gehäuses 12 des Mikroschalters 6 hinein, um den Mikroschalter 6 in seiner Lage in einer Ebene (X-Y-Ebene) senkrecht zur Klemmrichtung (Z-Richtung) zusätzlich zu fixieren.

Der Mikroschalter 6 weist beispielsweise zwei Steckfüße 28 mit bevorzugt rechtreckförmigem Querschnitt auf, welche senkrecht zu seiner Plattenebene bzw. zu seinen Seitenflächen und zur Leiterplatte 2 angeordnet sind und bevorzugt in Aufnahmebohrungen 30 der Leiterplatte aufgenommen bzw. dort gebondet sind, um Leiterbahnen auf der Leiterplatte 2 elektrisch kontaktieren zu können. Dadurch kann der Mikroschalter 6 elektrische Signale an die Leiterplatte 2 übertragen, um sie von dort an eine elektronische, aber von der hier gezeigten Leiterplatte 2 bevorzugt getrennten Auswerteelektronik weiter zu leiten. In diesem Fall spannen die durch die Klemmung des Mikroschalters 6 zwischen der Leiterplatte 2 und dem Leiterplattenträger 4 hervorgerufenen Normalkräfte auch die elektrischen Kontakte oder Steckfüße 28 des Mikroschalters 6 in die zugeordneten Aufnahmebohrungen 30 der Leiterplatte 2 vor, um die elektrische Kontaktierung zu stabilisieren. Damit sind die elektrischen Kontakte 28 des Mikroschalters 6, welche zum Anschluss an die Leiterplatte 2 vorgesehen sind, direkt, d.h. ohne weitere Verbindungsmittel wie etwa Kabel oder Leitungen mit den zugeordneten Leiterbahnen auf der Leiterplatte 2 verbunden.

Alternativ könnten die in Aufnahmebohrungen 30 der Leiterplatte 2 aufgenommenen und dort gebondeten elektrischen Steckfüße 28 beispielsweise seitlich am Mikroschalter 6 angeordnet sein, wobei in diesem Fall die Klemmkräfte die Kontaktierung ebenfalls unterstützen können. Nicht zuletzt könnten elektrischen Kontakte zwischen dem Mikroschalter 6 und der Leiterplatte 2 auch frei von Klemmkräften sein, indem die elektrischen Kontaktfüße 28 des Mikroschalters 6 indirekt, d.h. mittels Leitungen oder Drähten mit den zugeordneten Leiterbahnen der Leiterplatte 2 verbunden werden.

### Bezugszeichenliste

- 1: Leiterplattenanordnung
- 2: Leiterplatte
- 4: Leiterplattenträger
- 6: Mikroschalter
- 8: Betätigungsrichtung
- 10: Betätigungselement
- 12: Gehäuse
- 14: Durchgangsbohrung
- 16: Durchgangsbohrung
- 18: Schrauben
- 20: Schraubdome
- 22: Durchgangsbohrungen
- 24: Seitenflächen
- 26: Haltestifte
- 28: Steckfüße
- 30: Aufnahmebohrung

## Patentansprüche

1. Leiterplattenanordnung (1) mit einer mit Bauteilen bestückbaren Leiterplatte (2), welche wenigstens einen Mikroschalter (6) umfassen, wobei die Leiterplatte (2) an einem Leiterplattenträger (4) befestigt ist, **dadurch gekennzeichnet, dass** der Mikroschalter (6) zwischen der Leiterplatte (2) und dem Leiterplattenträger (4) aufgrund der durch die Befestigung der Leiterplatte (2) am Leiterplattenträger (4) hervorgerufenen Normalkräfte wenigstens mittels reibschlüssiger Klemmung gehalten ist.

2. Leiterplattenanordnung nach Anspruch 1, **dadurch gekennzeichnet, dass** die Leiterplatte (2) wenigstens zwei Durchgangsbohrungen (22) aufweist, durch welche am Leiterplattenträger (4) gekonterte Schrauben (18) ragen.

3. Leiterplattenanordnung nach Anspruch 1, **dadurch gekennzeichnet, dass** ein Gehäuse (12) des Mikroschalters (6) plattenförmig ausgebildet ist, wobei das Gehäuse (12) an parallel zur Plattenebene verlaufenden Seitenflächen (24) zwischen dem Leiterplattenträger (4) und der Leiterplatte (2) wenigstens reibschlüssig geklemmt ist.

4. Leiterplattenanordnung nach einem der vorhergehenden Ansprüche, **dadurch gekennzeichnet, dass** das Gehäuse (12) des Mikroschalters (6) wenigstens zwei in Klemmrichtung verlaufende Durchgangsbohrungen (14 16) aufweist, in welche vom Leiterplattenträger (4) weg ragende Haltestifte (26) hineinragen, um den Mikroschalter (6) in seiner Lage in einer Ebene senkrecht zur Klemmrichtung zu fixieren.

5. Leiterplattenanordnung nach einem der vorhergehenden Ansprüche, **dadurch gekennzeichnet, dass** die Betätigungsrichtung (8) eines aus dem Gehäuse (12) ragenden Betätigungselements (10) des Mikroschalters (6) im wesentlichen senkrecht zu den durch die Klemmung zwischen der Leiterplatte (2) und dem Leiterplattenträger (4) hervorgerufenen Normalkräften ist.

6. Leiterplattenanordnung nach einem der vorhergehenden Ansprüche, **dadurch gekennzeichnet, dass** die durch die Klemmung des Mikroschalters (6) zwischen der Leiterplatte (2) und dem Leiterplattenträger (4) hervorgerufenen Normalkräfte elektrische Kontakte (28) des Mikroschalters (6) gegen korrespondierende elektrische Kontakte der Leiterplatte (2) vorspannen.

7. Fußbremsmodul beinhaltend wenigstens ein Fußbremspedal einer Bremsanlage eines Fahrzeugs beinhaltend wenigstens eine Leiterplattenanordnung (1) nach einem der vorhergehenden Ansprüche.

8. Fußbremsmodul nach Anspruch 7, **gekennzeichnet durch** einen Kolben, welcher das Betätigungselement (10) des Mikroschalters (6) in Betätigungsrichtung (8) betätigt.

## Claims

1. A printed circuit board arrangement (1) having a printed circuit board (2) which can be populated with components which include at least one microswitch (6), wherein the printed circuit board (2) is fastened to a printed circuit board carrier (4), **characterized in that** the microswitch (6) is held between the printed circuit board (2) and the printed circuit board carrier (4) at least by means of frictional clamping owing to the normal forces which are caused by the printed circuit board (2) being fastened to the printed circuit board carrier (4).

2. The printed circuit board arrangement as claimed in claim 1, **characterized in that** the printed circuit board (2) has at least two passage holes (22) through which screws (18) which are secured to the printed circuit board carrier (4) project.

3. The printed circuit board arrangement as claimed in claim 1, **characterized in that** a housing (12) of the microswitch (6) is designed in the form of a plate, wherein the housing (12) is at least frictionally clamped between the printed circuit board carrier (4) and the printed circuit board (2) at side faces (24) which run parallel to the plate plane.

4. The printed circuit board arrangement as claimed in one of the preceding claims, **characterized in that** the housing (12) of the microswitch (6) has at least two passage holes (14, 16) which run in the clamping direction and into which holding pins (26), which project away from the printed circuit board carrier (4), project in order to fix the microswitch (6) in its position in a plane perpendicular to the clamping direction.

5. The printed circuit board arrangement as claimed in one of the preceding claims, **characterized in that** the operating direction (8) of an operating element (10), which projects out of the housing (12), of the microswitch (6) is substantially perpendicular to the normal forces which are caused by the clamping between the printed circuit board (2) and the printed circuit board carrier (4).

6. The printed circuit board arrangement as claimed in one of the preceding claims, **characterized in that** the normal forces which are caused by the clamping of the microswitch (6) between the printed circuit board (2) and the printed circuit board carrier (4) prestress electrical contacts (28) of the microswitch (6) against corresponding electrical contacts of the printed circuit board (2).

7. A foot brake module containing at least one foot brake pedal of a brake system of a vehicle, containing at least one printed circuit board arrangement (1) as claimed in one of the preceding claims.

8. A foot brake module as claimed in claim 7, **characterized by** a piston which operates the operating element (10) of the microswitch (6) in the operating direction (8).

## Revendications

1. Ensemble à carte de circuit imprimé (1) à une carte de circuit imprimé (2) apte à être équipé des composant, qui comprennent au moins un micro contacteur (6), dans lequel ladite carte de circuit imprimé (2) est fixée à un support de carte de circuit imprimé (4), **caractérisé en ce que** ledit micro contacteur (6) est retenu entre ladite carte de circuit imprimé (2) et ledit support de carte de circuit imprimé (4) au moins moyennant un effet de serrage par friction en vertu des efforts normaux causés par la fixation de ladite carte de circuit imprimé (2) audit support de carte de circuit imprimé (4).

2. Ensemble à carte de circuit imprimé selon la revendication 1, **caractérisé en ce que** ladite carte de circuit imprimé (2) présente au moins deux alésages de passage (22), à travers lesquels des vis (18) s'étendent, qui sont bloquées par écrou audit support de carte de circuit imprimé (4).

3. Ensemble à carte de circuit imprimé selon une quelconque des revendications précédentes, **caractérisé en ce qu'**un carter (12) dudit micro contacteur (6) a une configuration en plaque, audit carter (12) étant serré au moins par friction aux faces latérales (24) s'étendant en parallèle au plan de la plaque entre ledit support de carte de circuit imprimé (4) et ladite carte de circuit imprimé (2).

4. Ensemble à carte de circuit imprimé selon une quelconque des revendications précédentes, **caractérisé en ce que** ledit carter (12) dudit micro contacteur (6) est muni d'au moins deux alésages de passage (14, 16) s'étendant en sens de serrage, dans lesquels s'étendent des goupilles de maintien (26), qui font saillie dudit support de carte de circuit imprimé (4), afin de fixer ledit micro contacteur (6) en sa position dans un plan orthogonal au sens de serrage.

5. Ensemble à carte de circuit imprimé selon la revendication 4, **caractérisé en ce que** le sens d'actionnement (8) d'un élément actionneur (10) dudit micro contacteur (6), qui fait saillie dudit carter (12), est essentiellement orthogonal sur les efforts normaux induits par le serrage entre ladite carte de circuit imprimé (2) et ledit support de carte de circuit imprimé (4).

6. Ensemble à carte de circuit imprimé selon une quelconque des revendications précédentes, **caractérisé en ce que** des efforts normaux induits par le serrage dudit micro contacteur (6) entre ladite carte de circuit imprimé (2) et ledit support de carte de circuit imprimé (4) mettent en précontrainte des contact électriques (28) dudit micro contacteur (6) contre des contacts électriques correspondants de ladite carte de circuit imprimé (2).

7. Module de pédale de frein, comportant au moins une pédale de frein d'un système de freinage d'un véhicule, comprenant au moins un ensemble à carte de circuit imprimé (1) selon une quelconque des revendications précédentes.

8. Module de pédale de frein selon la revendication 7, **caractérisé par** un piston actionnant ledit élément actionneur (10) dudit micro contacteur (6) en sens d'actionnement.
